(19) Europäisches Patentamt
European Patent Office
Office européen des brevets

(11) **EP 1 806 328 A1**

(12) **EUROPEAN PATENT APPLICATION**
published in accordance with Art. 158(3) EPC

(43) Date of publication:
**11.07.2007 Bulletin 2007/28**

(51) Int Cl.:
***C04B 35/58*** *(2006.01)*    ***H01B 13/00*** *(2006.01)*
***C01G 1/00*** *(2006.01)*    ***H01B 12/10*** *(2006.01)*
***C01B 35/04*** *(2006.01)*

(21) Application number: **05799015.2**

(22) Date of filing: **25.10.2005**

(86) International application number:
**PCT/JP2005/019554**

(87) International publication number:
**WO 2006/046535 (04.05.2006 Gazette 2006/18)**

(84) Designated Contracting States:
**DE FR GB IT**

(30) Priority: **28.10.2004 JP 2004314226**

(71) Applicant: **Sumitomo Electric Industries, Ltd.**
**Osaka-shi, Osaka 541-0041 (JP)**

(72) Inventors:
• **SHIMOYAMA, Jun-ichi**
**Graduate School of Engineering**
**Tokyo 113-8656 (JP)**

• **KATO, Takeshi,**
**SUMITOMO ELECTRIC INDUSTRIES, LTD.**
**Osaka-shi,**
**Osaka 554-8511 (JP)**

(74) Representative: **Kreutzer, Ulrich**
**Cabinet Beau de Loménie**
**Bavariaring 26**
**80336 München (DE)**

(54) **SINTERED BODY, SUPERCONDUCTING DEVICE, SINTERED BODY MANUFACTURING METHOD, SUPERCONDUCTING WIRING ROD AND SUPERCONDUCTING WIRING ROD MANUFACTURING METHOD**

(57)    A method of manufacturing a sintered body, which is a method of manufacturing a sintered body containing Mg and B, comprises the arrangement and heat treatment steps of arranging Mg powder (3a, 3b) and B powder (2) without mixing the Mg powder and the B powder with each other and heat-treating the Mg powder (3a, 3b) and the B powder (2) after the arrangement step. The temperature in the heat treatment step is at least 651°C and not more than 1107°C. Thus, the critical current density can be improved.

FIG.4

**Description**

**Technical Field**

The present invention relates to a sintered body, a superconducting apparatus, a method of manufacturing a sintered body, a superconducting wire and a method of manufacturing a superconducting wire.

**Background Art**

When employing a sintered body of $MgB_2$ as superconductor filaments of a superconducting wire, a high critical temperature can be implemented. Therefore, the sintered body of $MgB_2$ is widely noticed. A superconducting wire employing the sintered body of $MgB_2$ can be manufactured by the following method (first manufacturing method), for example:

A plurality of metal pipes charged with superconducting powder constituted of reacted $MgB_2$ are wire-drawn and introduced into a metal pipe for obtaining a multifilamentary structure. Then, the multifilamentary structure is wire-drawn into a prescribed size, and thereafter heat-treated at a prescribed temperature.

The following method is also known as another manufacturing method (second manufacturing method): Raw material powder is prepared by mixing powder of Mg (magnesium) and powder ofB (boron) serving as raw materials for $MgB_2$ with each other to be in a random state. A plurality of metal pipes charged with this raw material powder are wire-drawn and introduced into a metal pipe for obtaining a multifilamentary structure. Then, the multifilamentary structure is wire-drawn into a prescribed size, and thereafter heat-treated at a prescribed temperature.

The aforementioned methods of manufacturing superconducting wires of $MgB_2$ are disclosed in non-patent literature 1 to 3, for example. In particular, non-patent literature 1 describes that a superconducting wire manufactured by the aforementioned second manufacturing method attains a higher critical current density than a superconducting wire manufactured by the aforementioned first manufacturing method.

Non-Patent Literature 1: Alexey, V. Pan, et al., "Properties of superconducting MgB2 wires: in situ versus ex situ reaction technique", Supercond. Sci. Technol. 16 (2003) pp. 639-644

Non-Patent Literature 2: X. L. Wang, et. al., "Significant improvement of critical current density in coated MgB2/Cu short tapes through nano-SiC doping and short-time in situ reaction", Supercond. Sci. Technol. 17 (2004) pp. L21-L24

Non-Patent Literature 3 : A. Matsumoto, et al., "Effect of impurity additions on the microstructures and superconducting properties of in situ-processed MgB2 tapes", Supercond. Sci. Technol. 17 (2004) pp. S319-S323

**Disclosure of the Invention**

**Problems to be Solved by the Invention**

In the superconducting wire obtained by the second manufacturing method, however, the sintering density of superconductor filaments has been at a low level of about 50 %. A superconducting wire has such a property that the critical current value is reduced when the density of superconductor filaments is low. Therefore, it has been impossible to attain a sufficiently high critical current density when manufacturing a superconducting wire of $MgB_2$ by the second manufacturing method.

Accordingly, an object of the present invention is to provide a sintered body capable of improving the critical current density, a superconducting apparatus, a method of manufacturing a sintered body, a superconducting wire and a method of manufacturing a superconducting wire.

**Means for Solving the Problems**

The sintered body according to the present invention contains Mg and B, and has a sintering density of at least 90 %. According to the inventive sintered body, the critical current density can be improved when applied to a superconducting wire. The sintered body according to the present invention can be manufactured by the following method, for example:

The method of manufacturing a sintered body according to the present invention, which is a method of manufacturing a sintered body containing Mg and B, comprises the arrangement and heat treatment steps of arranging Mg and B without mixing Mg and B with each other and heat-treating Mg and B after the arrangement step.

The inventors have found the reason why it has generally been impossible to attain a sufficiently high critical current density when applying a sintered body of $MgB_2$ to a superconducting wire. When heat-treating raw material powder containing magnesium and boron, Mg diffuses and moves toward B. Consequently, a void results in a portion where Mg has been present, and a sintered body of $MgB_2$ is generated in a portion where B has been present. The density of the sintered body is reduced due to such formation of the void, and hence it has been impossible to attain a sufficiently high critical current density when applying the sintered body of $M_gB_2$ to the superconducting wire.

In the method of manufacturing a sintered body according to the present invention, therefore, Mg and B are heated in a mutually unmixedly arranged state. Thus, a portion where Mg has been present is not included in part of the sintered body, whereby the sintering density of the sintered body is not reduced. Therefore, the sintering density of the sintered body containing Mg and B can be improved, and the critical current density of a superconducting wire can be improved by employing this sintered body.

Preferably in the aforementioned manufacturing method, the temperature in the heat treatment step is at least 651°C and not more than 1107°C.

Since the melting point of Mg is 651°C, Mg is liquefied and the diffusion rate of Mg is remarkably improved due to the heat treatment at the temperature exceeding this level. Since the boiling point of Mg is 1107°C, Mg can be prevented from extinction resulting from vaporization due to the heat treatment at the temperature below this level.

Preferably in the aforementioned manufacturing step, the arrangement step includes the steps of preparing a mixture by mixing at least either silicon carbide or tetraboron carbide and B with each other and arranging Mg and this mixture without mixing Mg and the mixture with each other.

Thus, a sintered body containing at least either silicon carbide or tetraboron carbide can be obtained. The critical current density of the superconducting wire can be further improved by this sintered body.

The superconducting wire according to the present invention has a superconductor filament containing Mg and B, and the sintering density of the superconductor filament is at least 90 %. The superconducting apparatus according to the present invention employs the aforementioned sintered body or the aforementioned superconducting wire.

According to the inventive superconducting wire and the inventive superconducting apparatus, the critical current density can be improved. The superconducting wire according to the present invention can be manufactured by the following manufacturing method, for example:

The method of manufacturing a superconducting wire according to the present invention comprises the wire preparation and heat treatment steps of preparing a wire having a configuration obtained by covering a raw material body containing Mg and B not mixed with each other with a metal and heat-treating the wire.

In the method of manufacturing a superconducting wire according to the present invention, Mg and B are heat-treated in a mutually unmixedly arranged state. Thus, a portion where Mg has been present is not included in part of the sintered body, whereby the sintering density of the superconductor filament is not reduced. Therefore, the sintering density of the superconductor filament containing Mg and B can be improved, and the critical current density of the superconducting wire can be improved.

Preferably in the aforementioned manufacturing method, the temperature in the heat treatment step is at least 651°C and not more than 1107°C.

Since the melting point of Mg is 651°C, Mg is liquefied and the diffusion rate of Mg is remarkably improved due to the heat treatment at the temperature exceeding this level. Since the boiling point of Mg is 1107°C, Mg can be prevented from extinction resulting from vaporization due to the heat treatment at the temperature below this level.

Preferably in the aforementioned manufacturing method, the wire preparation step includes the steps of preparing a mixture by mixing at least either silicon carbide or tetraboron carbide and B with each other and preparing the wire having a configuration obtained by covering the raw material body containing Mg and the mixture not mixed with each other with the metal.

Thus, a superconducting wire having the superconductor filament containing at least either silicon carbide or tetraboron carbide can be obtained, and the critical current density of the superconducting wire can be further improved.

Preferably in the aforementioned manufacturing method, a low melting point metal having a melting point lower than the temperature of the heat treatment is injected into a portion where Mg has been present after the heat treatment step.

Thus, a cavity present in the superconductor filament generated by reaction of the raw material body can be filled up with the low melting point metal, whereby the superconductor can be stabilized as a result.

Preferably in the aforementioned manufacturing method, Mg is so arranged as to extend in the longitudinal direction of the wire and B is so arranged as to enclose Mg in a section perpendicular to the longitudinal direction in the wire preparation step.

Thus, the overall section perpendicular to the longitudinal direction of the superconducting wire can be inhibited from formation of a void. Since current flows along the longitudinal direction of the superconducting wire, a void can be inhibited from disturbing a conductive path, and the critical current density can be improved.

Preferably in the aforementioned manufacturing method, Mg and B are so arranged that the entire B is present at a distance of at least 0 mm and not more than 1 mm from the boundary surface between Mg and B immediately before the heat treatment step.

The diffusion length of Mg in the heat treatment step is preferably 1 mm. In order to diffuse Mg over a distance longer than 1 mm, heat treatment of an extremely long time is required. When arranging the entire B at the distance of not more than 1 mm from the boundary surface between Mg and B immediately before the heat treatment step, therefore, Mg diffuses into the entire B in a short time, whereby the heat treatment time can be reduced.

Throughout the specification, the wording "without mixing Mg and B" means "without bringing particles of Mg and particles of B into a random state". The wording "without mixing Mg and the mixture with each other" means "without bringing particles of Mg and particles of the mixture into a random state".

**Effect of the Invention**

According to the present invention, the critical current density can be improved.

**Brief Description of the Drawings**

Fig. 1 is a perspective view showing a structure of a sintered body according to a first embodiment of the present invention.

Fig. 2 is a perspective view showing another structure of the sintered body according to the first embodiment of the present invention.

Fig. 3 is a perspective view showing still another structure of the sintered body according to the first embodiment of the present invention.

Fig. 4 is a sectional view showing a method of charging raw material powder in the first embodiment of the present invention.

Fig. 5 is a sectional view showing another method of charging raw material powder in the first embodiment of the present invention.

Fig. 6 is a sectional view showing still another method of charging raw material powder in the first embodiment of the present invention.

Fig. 7 is a sectional view showing the structure of a heat-treated sintered body.

Figs. 8(a) to (c) are sectional views showing changes of Mg powder and B powder in heat treatment in a conventional manufacturing method stepwise. Figs. 8(a), (b) and (c) illustrate a first stage, a second stage and a third stage respectively.

Fig. 9 is a microphotograph showing a section of a sintered body obtained by the conventional manufacturing method.

Figs. 10(a) to (c) are sectional views showing changes of Mg powder and B powder in heat treatment in a manufacturing method according to the first embodiment of the present invention stepwise. Figs. 10(a), (b) and (c) illustrate a first stage, a second stage and a third stage respectively.

Fig. 11(a) is a microphotograph showing a section of a sintered body obtained by the manufacturing method according to the first embodiment of the present invention. Fig. 11(b) is an enlarged view of Fig. 11(a).

Fig. 12 is a partially fragmented perspective view schematically showing the structure of a superconducting wire according to a third embodiment of the present invention.

Fig. 13 is a partially fragmented perspective view showing the structure of a wire having a configuration obtained by covering raw material powder with a metal pipe in the third embodiment of the present invention.

Fig. 14 is a perspective view schematically showing a step of bundling a large number of single-filamentary wires and engaging the same into a metal pipe.

Fig. 15 is a sectional view of a principal portion showing a state of raw material powder immediately before preparation of a multifilamentary wire (immediately before heat treatment).

Fig. 16 is a diagram showing the relation between applied magnetic field H and critical current density $J_e$ of a superconducting wire according to Example 1.

Fig. 17 is a diagram showing the relation between applied magnetic field H and critical current density $J_e$ of a superconducting wire according to Example 2.

Fig. 18 is a diagram showing the relation between applied magnetic field H and critical current density $J_c$ of a superconducting wire according to Example 3.

**Description of Reference Numerals**

1, 10 sintered body (superconductor filament), 1a to 1c sintered body, 2,102 B powder, 3, 3a, 3b, 103 Mg powder, 5, 105 void, 10 superconducting wire, 10a single-filamentary wire, 11 sheath, 11a, 11b metal pipe, 20 cavity, 31 container, 31 lid.

**Best Modes for Carrying Out the Invention**

Embodiments of the present invention are now described with reference to the drawings.

(First Embodiment)

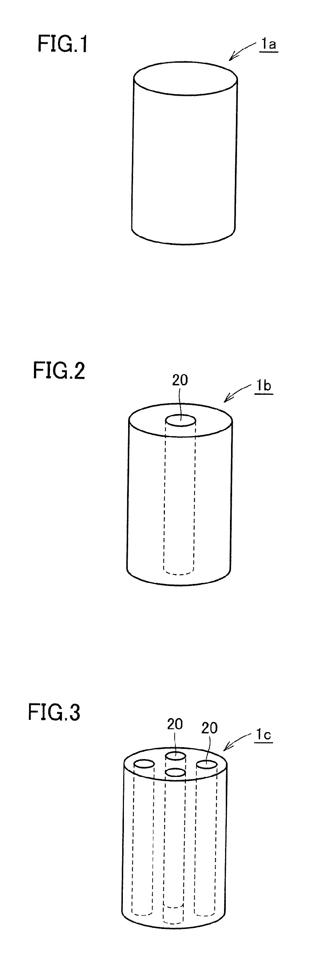

Figs. 1 to 3 are perspective views showing the structure of sintered bodies according to a first embodiment of the present invention.

As shown in Figs. 1 to 3, the sintered bodies according to this embodiment are made of $MgB_2$, for example, and the shapes thereof are arbitrary. For example, a sintered body 1a shown in Fig. 1 has a cylindrical shape. A sintered body shown in Fig. 2 has a cylindrical shape with a cylindrical cavity 20 present on the central portion. Further, a sintered body shown in Fig. 3 has a cylindrical shape with a plurality of cylindrical cavities 20 present along the circumferential direction. The sintering densities of sintered bodies 1a to 1c are at least 90 %.

The sintering density of a sintered body is calculated by the following method:

First, the sintered body is cut into a sintered body of a constant mass (M (g)). Then, the cut sintered body is dipped in alcohol, so that the mass (W (g)) of a wire in alcohol is measured for calculating buoyancy acting on the sintered body. The volume (V ($cm^3$)) of the sintered body is calculated with a known alcohol density ($\rho = 0.789$ ($g/cm^3$)). More specifically, V is calculated through the following expressions (1) and (2), assuming that F represents the buoyancy. The portion of cavity (cavities) 20 in sintered body 1b or 1c is not included in the volume V of the sintered body, as a matter of course.

$$F = M - W \ \dots \ (1)$$

$$V = F/\rho \ \dots \ (2)$$

The density $\rho$ of the sintered body is calculated from the volume V of the sintered body obtained in this manner through the following expression (3):

$$\rho = M/V \ \dots \ (3)$$

When the sintered body is made of $MgB_2$, a value 2.63 $g/cm^3$ is employed as the theoretical density thereof. The sintering density of the sintered body is calculated from the ratio between this theoretical density of the sintered body and the density $\rho$ of the sintered body. More specifically, the sintering density is calculated through the expression (4).

$$\text{Sintering density (\%)} = (\rho/2.63) \times 100 \ \dots \ (4)$$

A method of manufacturing a sintered body according to this embodiment is now described. In this embodiment, a method of manufacturing sintered body 1a is described in particular.

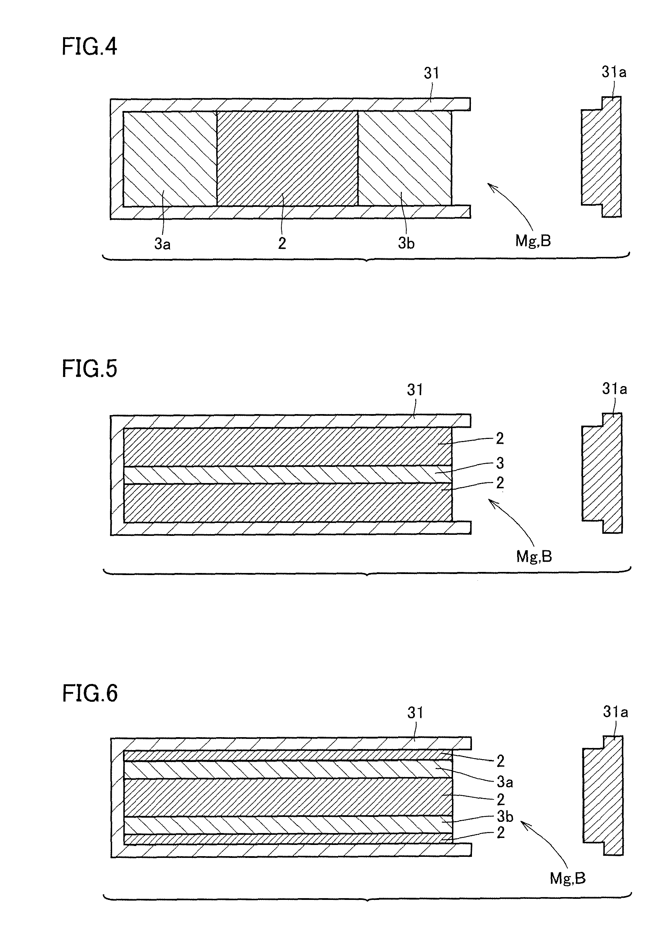

Referring to Fig. 4, Mg powder is first divided into two, and first Mg powder 3 a is charged into a cylindrical container 31. Then, B powder 2 is charged onto Mg powder 3 a in container 31. In charging of B powder 2, B powder 2 is brought into the shape of a desired sintered body. Then, remaining Mg powder 3b is charged onto B powder 2 in container 31. Thereafter an opening of container 31 is covered with a lid 31a.

Thus, according to this embodiment, the Mg powder and the B powder are charged (arranged) in container 31 in a mutually unmixed state. When Mg powder 3 a, Mg powder 3b and B powder 2 are totally regarded as single raw material powder, particles constituting the Mg powder and particles constituting the B powder are not present in a mutually random state in the raw material powder. The sizes of the particles constituting the Mg powder and the B powder are arbitrary. The B powder not yet heat-treated is preferably densified by a method such as compression powder molding. Thus, the obtained sintered body can also be densified.

In order to manufacture sintered body 1b or 1c, Mg powder and B powder are charged in the following manner: Referring to Fig. 5, Mg powder 3 is charged into a portion for forming cavity 20, and B powder 2 is charged to cover the periphery thereof, in order to manufacture sintered body 1b. In other words, the Mg powder solidified in the form of a bar is arranged in the central axial portion of container 31. Or, a bar of Mg is arranged. Referring to Fig. 6, Mg powder 3a and Mg powder 3b are charged into four portions for forming cavities 20 and B powder 2 is charged to cover the peripheries thereof, in order to manufacture sintered body 1c.

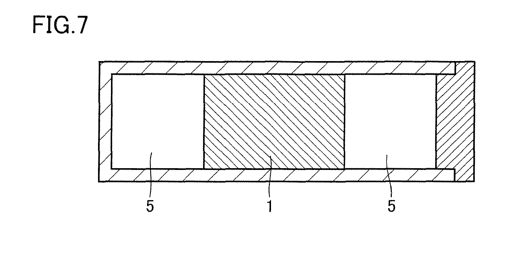

Then, the aforementioned Mg powder and B powder are heat-treated at a temperature of at least 651°C and not more than 1107°C, for example. Thus, the Mg powder and the B powder react to generate a sintered body of $MgB_2$. Fig. 7 shows the structure of a heat-treated sintered body in a case of heat-treating the raw material powder shown in Fig. 4. As shown in Fig. 7, a sintered body 1 is generated in a shape substantially close to the shape ofB powder 2 not yet heat-treated. A void (cavity) 5 is formed in a portion where Mg powder 3 has been present. Thereafter this sintered body 1 is taken out from container 31. Sintered body 1a shown in Fig. 1 is obtained through the aforementioned steps.

The inventors have found the reason why it has generally been impossible to attain a sufficiently high critical current density when applying a sintered body of $MgB_2$ to a superconducting wire. This is now described.

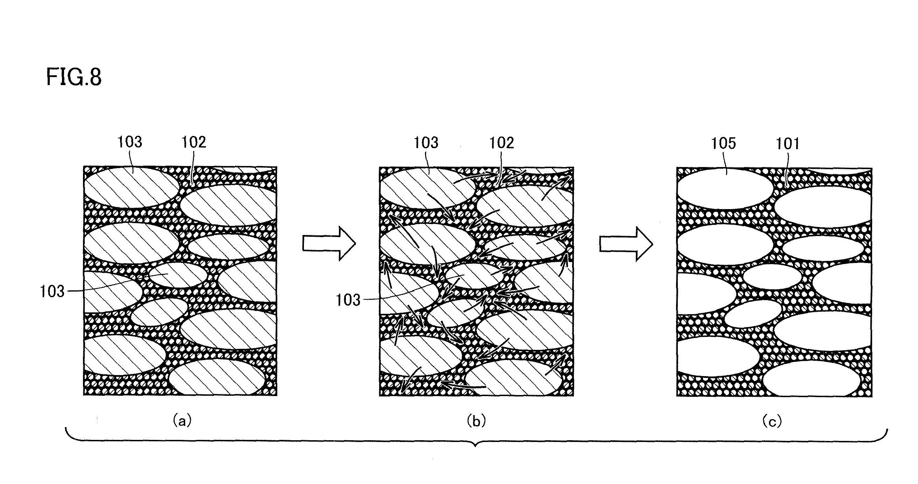

Figs. 8(a) to (c) are sectional views showing changes of Mg powder and B powder in heat treatment in a conventional manufacturing method stepwise. In general, raw material powder has been prepared by mixing Mg powder and B powder with each other, in order to accelerate reaction between Mg and B. Therefore, particles constituting Mg powder 103 and particles constituting B powder 102 have been present in a random state in the raw material powder, as shown in Fig. 8(a). When this raw material powder is heat-treated, Mg diffuses and moves in the direction of B (along arrow), as shown in Fig. 8(b). Consequently, voids 105 are formed in portions where Mg powder 103 has been present, and a sintered body 101 of $MgB_2$ is generated in the portion where B powder 102 has been present. In other words, voids 105 are formed in sintered body 101.

Thus, voids have been formed in the sintered body to reduce the sintering density of the sintered body in the conventional manufacturing method. When applying the sintered body of $MgB_2$ to a superconducting wire, therefore, these voids have so disturbed a conductive path that it has been impossible attain a sufficiently high critical current density.

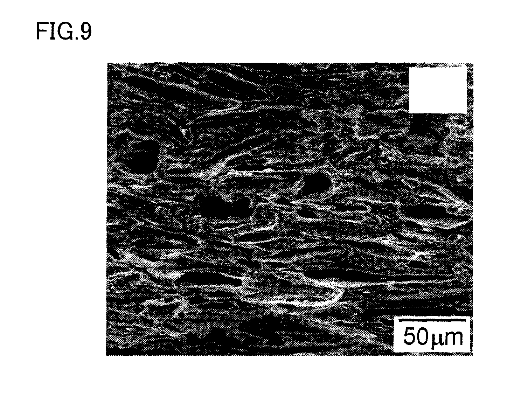

Fig. 9 is a microphotograph showing a section of a sintered body obtained by the conventional manufacturing method. As shown in Fig. 9, it is understood that voids of about 20 $\mu$m to about 50 $\mu$m in diameter are formed in the sintered body obtained by the conventional manufacturing method.

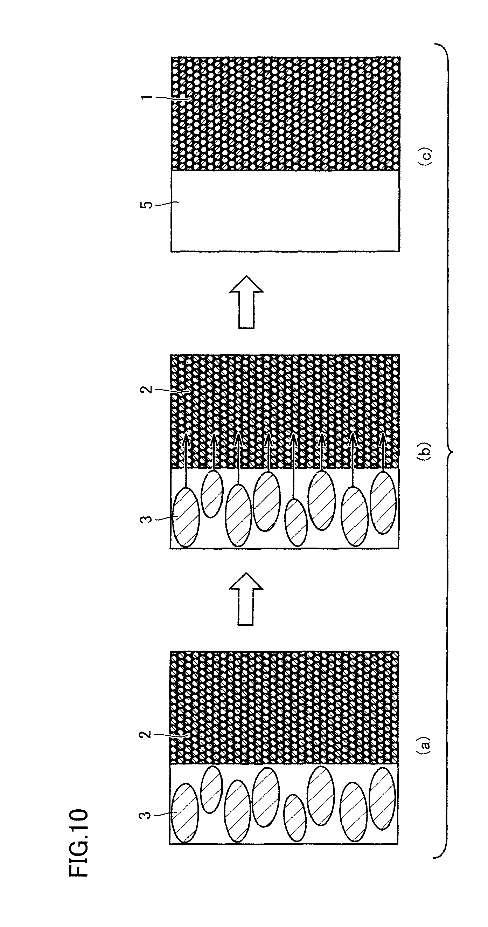

Figs. 10(a) to (c) are sectional views showing changes of Mg powder and B powder in heat treatment in the manufacturing method according to the first embodiment of the present invention stepwise. Figs. 10(a) to (c) show the boundary between Mg powder 3a and B powder 2 in Fig. 4. In the method of manufacturing a sintered body according to this embodiment, the Mg powder and the B powder are heat-treated in a mutually unmixedly arranged state. Therefore, a clear boundary line can be drawn between the region where Mg powder 3 (3a) is present and the region where B powder 2 is present in the raw material powder, as shown in Fig. 10(a). When the raw material powder in which the Mg powder and the B powder are arranged in this manner is heat-treated, Mg diffuses and moves in the direction ofB (along arrow), as shown in Fig. 10(b). Consequently, a void (cavity) 5 is formed in the portion where Mg powder 3 has been present and a sintered body 1 of $MgB_2$ is formed in the portion where B powder 2 has been present, as shown in Fig. 10(c). In other words, no void 5 is formed in sintered body 1.

Thus, no void is formed in the sintered body in the manufacturing method according to this embodiment, whereby the sintering density of the sintered body is not reduced. Therefore, no void disturbs a conductive path, whereby the sintering density of the sintered body of $MgB_2$ can be improved (to at least 90 %, for example). The critical current density of a superconducting wire can be improved by employing this sintered body.

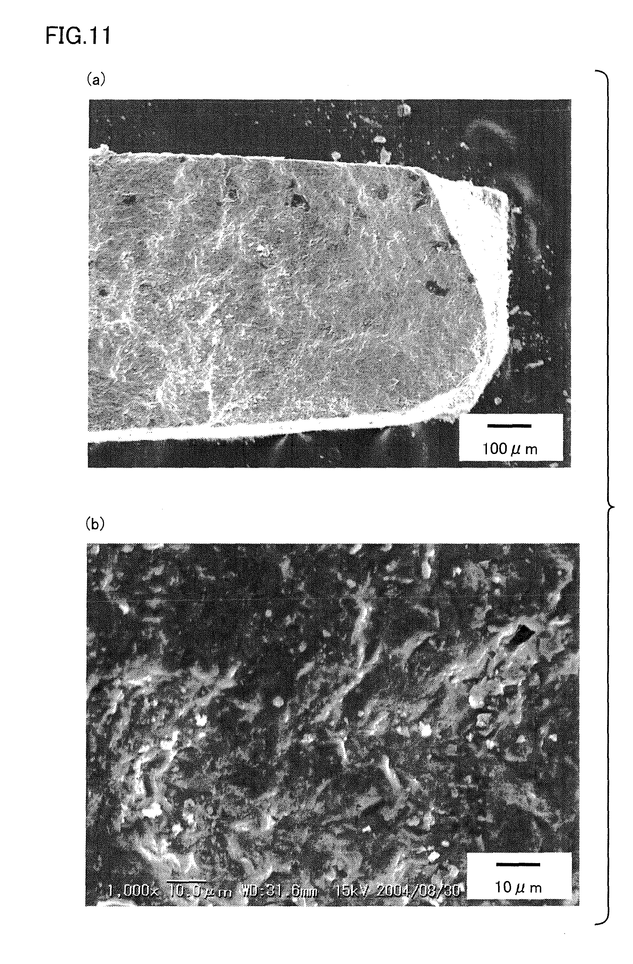

Figs. 11(a) and (b) are microphotographs showing sections of a sintered body obtained by the manufacturing method according to the first embodiment of the present invention. As shown in Figs. 11(a) and (b), it is understood that substantially no void is formed in the sintered body obtained by the manufacturing method according to this embodiment.

In the aforementioned manufacturing method, Mg powder and B powder are heat- treated at a temperature of at least 651°C and not more than 1107°C.

Since the melting point of Mg is 651°C, Mg is liquefied and the diffusion rate of Mg is remarkably improved due to the heat treatment at the temperature exceeding this level. Since the boiling point of Mg is 1107°C, Mg can be prevented from extinction resulting from vaporization due to the heat treatment at the temperature below this level.

(Second Embodiment)

The case where the raw material powder is formed by only Mg powder and B powder has been shown in relation to the manufacturing method according to the first embodiment. According to the present invention, however, the raw material powder may contain still another material, for example, in place of this case.

In a method of manufacturing a sintered body according to this embodiment, mixed powder (mixture) is prepared by mixing SiC (silicon carbide) and $B_4C$ (tetraboron carbide) with B powder. Mg powder and this mixed powder are arranged in a mutually unmixed state. Referring to Fig. 4, for example, the mixed powder is arranged on the position where B powder 2 is arranged. Then, the aforementioned Mg powder and mixed powder are heat-treated. Thus, a

sintered body of $MgB_2$ containing SiC and $B_4C$ is generated.

The remaining manufacturing method is substantially similar to the first embodiment, and hence redundant description is not repeated.

In the method of manufacturing a sintered body according to this embodiment, the mixed powder is prepared by mixing SiC and $B_4C$ with B, and the powder of Mg and the mixed powder are arranged in a mutually unmixed state.

Thus, the sintered body containing SiC and $B_4C$ is obtained. The critical current density of a superconducting wire can be further improved with this sintered body.

While the case of preparing the mixed powder by mixing both of SiC and $B_4C$ with B in this embodiment, the present invention is not restricted to this case but the mixed powder may be prepared by mixing at least either SiC or $B_4C$ with B.

(Third Embodiment)

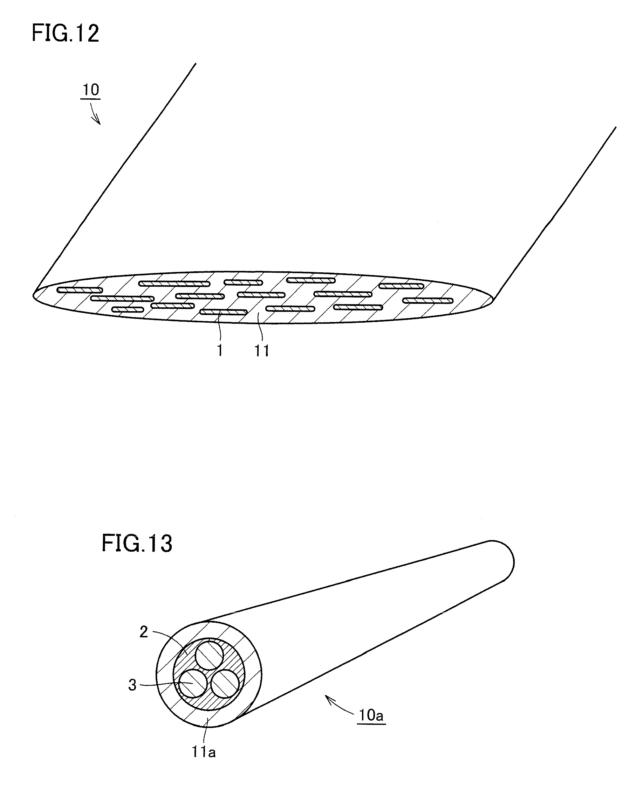

Fig. 12 is a partially fragmented perspective view schematically showing the structure of a superconducting wire according to a third embodiment of the present invention. With reference to Fig. 12, a multifilamentary superconducting wire, for example, is described. A superconducting wire 10 has a plurality of sintered bodies (superconductor filaments) 1 extending in the longitudinal direction and a sheath 11 covering the same. In other words, sintered bodies 1 in the first and second embodiments form superconductor filaments 1 in Fig. 12. Superconductor filaments 1 are made of $MgB_2$, for example. Sheath 11 is made of a metal such as stainless steel, copper or an alloy thereof, for example. The sintering density of superconductor filaments 1 is at least 90 %.

The sintering density of superconductor filaments is calculated by the following method:

First, a superconducting wire of a constant mass ($M_t$ (g)) is cut out. Then, the cut superconducting wire is dipped in alcohol, and the mass (W (g)) of the wire in alcohol is measured for calculating buoyancy acting on the superconducting wire. The volume ($V_t$ ($cm^3$)) of the superconducting wire is calculated with a known alcohol density ($\rho$ = 0.789 (g/ $cm^3$). More specifically, $V_t$ is calculated through the following expressions (5) and (6), assuming that $F_t$ represents the buoyancy:

$$F_t = M_t - W \ \ldots \ (5)$$

$$V_t = F_t/\rho \ \ldots \ (6)$$

Then, the superconducting wire is dissolved in nitric acid, and this solution is subjected to ICP (Inductive Coupled Plasma) spectrometry for determining a sheath, thereby calculating the ratio (Y) of the sheath occupying the mass of the superconducting wire. The mass ($M_f$ (g)) of a superconductor filament portion and the mass ($M_s$ (g)) of the sheath are calculated from the mass of the superconducting wire through the following expressions (7) and (8):

$$M_s = M_t \times Y \ \ldots \ (7)$$

$$M_f = M_t - M_s \ \ldots \ (8)$$

Then, the volume ($V_s$ ($cm^3$)) of the sheath is calculated from a known specific gravity (10.5 (g/$cm^3$) when the sheath is made of silver, for example), and the volume ($V_f$($cm^3$)) of the superconductor filaments is calculated from the volume of the sheath. The density $\rho_f$ of the superconductor filaments is calculated from the volume of the superconductor filaments. More specifically, $\rho_f$ is calculated through the following expressions (9) to (11):

$$V_s = M_s/10.5 \ \ldots \ (9)$$

$$V_f = V_t - V_s \ \ldots \ (10)$$

$$\rho_f = M_f/V_f \ \ldots \ (11)$$

When the superconductor filaments are made of MgB$_2$, on the other hand, the value 2.63 g/cm$^3$ is employed as the theoretical density thereof The sintering density of the superconductor filaments is calculated from the ratio between this theoretical density and the density ρ of the superconductor filaments. More specifically, the sintering density is calculated through the expression (12):

$$\text{Sintering density } (\%) = (\rho_f/2.63) \times 100 \ \ldots \ (12)$$

A method of manufacturing a superconducting wire according to this embodiment is now described.

Referring to Fig. 13, raw material powder (precursor, raw material body) for a superconductor is first charged in a metal pipe 11 a of a metal such as stainless steel, for example. This raw material powder for a superconductor contains Mg powder 3 and B powder 2 not mixed with each other. More specifically, Mg powder 3 solidified in the form of bars is arranged on three portions to extend in the longitudinal direction of metal pipe 11a, and B powder 2 is arranged to enclose the same. Further, B powder 2 is so arranged as to enclose Mg powder 3 in a section (section shown in Fig. 13) perpendicular to the longitudinal direction of metal pipe 11a.

The method of arranging the Mg powder and the B powder is not restricted to the above, but the Mg powder and the B powder may simply be in a mutually unmixed state.

Then, the aforementioned metal pipe 11 a is wire-drawn into a desired diameter, for preparing a single-filamentary wire 10a having a core of the precursor covered with a metal such as stainless steel. Thus, wire (single-filamentary wire) 10a having a configuration obtained by covering the raw material powder containing Mg powder 3 and the B powder not mixed with each other with metal pipe 11 a is obtained.

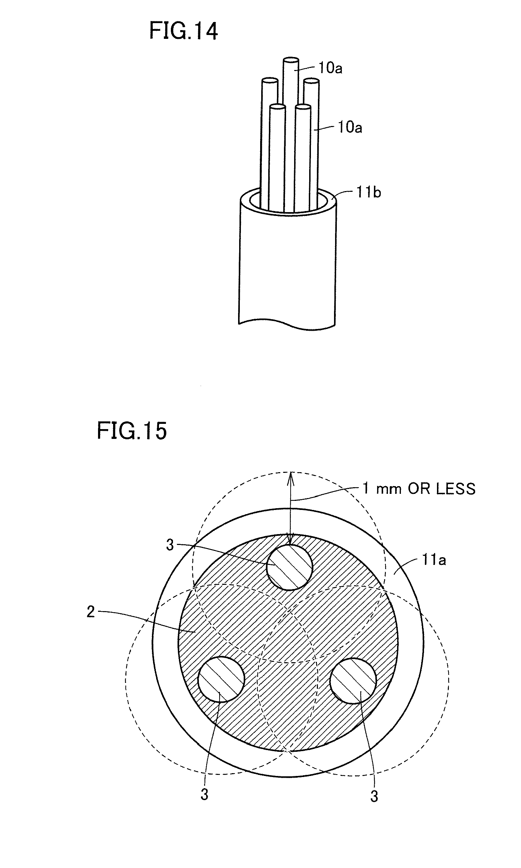

Referring to Fig. 14, a large number of single-filamentary wires 10a are bundled and engaged into a metal pipe 11b of a metal such as stainless steel, for example, for obtaining a multifilamentary structure. Then, this wire of the multifilamentary structure is wire-drawn into a desired diameter, for preparing a multifilamentary wire (may hereinafter be also referred to as wire) having the raw material powder embedded in a sheath.

Fig. 15 is a sectional view of a principal portion showing the state of the raw material powder immediately after preparation of the multifilamentary wire (immediately before heat treatment). Fig. 15 shows a section of a single-filamentary wire constituting the multifilamentary wire. Referring to Fig. 15, the entire B powder 2 is preferably present at a distance of at least 0 mm and not more than 1 mm from the boundary surface between Mg powder 3 and B powder 2 (in the ranges shown by dotted lines in Fig. 15) immediately before the heat treatment. In order to arrange Mg powder 3 and B powder 2 as shown in Fig. 15, to what degrees the diameters of the wires are reduced are measured in the wire drawing of the single-filamentary wires and the wire drawing of the multifilamentary wire respectively, for deciding the sizes and positions of Mg powder 3 and B powder 2 in Fig. 13 in response to the degrees of reduction of the diameters.

Then, the aforementioned multifilamentary wire is heat-treated. This heat treatment is performed at a temperature of at least 651°C and not more than 1107°C, for example. A superconducting phase of MgB$_2$ is generated from the raw material powder due to this heat treatment, for forming superconductor filaments. While cavities are formed after the heat treatment in the portions where Mg powder 3 has been present, these cavities, not included in superconductor filaments 1, hardly influence the performance of superconducting wire 10. Superconducting wire 10 shown in Fig. 12 is obtained through the aforementioned manufacturing steps.

The method of manufacturing a superconducting wire according to this embodiment comprises the wire preparation and heat treatment steps of preparing the wire having the configuration obtained by covering the raw material powder containing Mg powder 3 and B powder 2 not mixed with each other with metal pipe 11a and heat-treating the wire.

In the method of manufacturing a superconducting wire according to this embodiment, Mg powder 3 and B powder 2 are heat-treated in the mutually unmixedly arranged state. Thus, the portions where Mg has been present are not included in part of superconductor filaments 1, whereby the sintering density of superconductor filaments 1 is not reduced. Therefore, the sintering density of the superconductor filaments containing Mg and B can be improved, and the critical current density of the superconducting wire can be improved.

In the aforementioned manufacturing method, Mg powder 3 and B powder 2 are heat-treated at the temperature of at least 651°C and not more than 1107°C.

Since the melting point of Mg is 651°C, Mg is liquefied and the diffusion rate of Mg is remarkably improved due to the heat treatment at the temperature exceeding this level. Since the boiling point of Mg is 1107°C, Mg can be prevented from extinction resulting from vaporization due to the heat treatment at the temperature below this level.

In the aforementioned manufacturing method, Mg powder 3 is so arranged as to extend in the longitudinal direction of the wire and B powder 2 is so arranged as to enclose Mg powder 3 in the section perpendicular to the longitudinal direction in preparation of the wire.

Thus, formation of voids can be suppressed in the overall section perpendicular to the longitudinal direction of superconducting wire 10. Since current flows along the longitudinal direction of superconducting wire 10, voids can be inhibited from disturbing a conductive path, and the critical current density can be improved.

Preferably in the aforementioned manufacturing method, Mg powder 3 and B powder 2 are so arranged that the entire B powder 2 is present at the distance of at least 0 mm and not more than 1 mm from the boundary surface between Mg powder 3 and B powder 2 immediately before the heat treatment.

The diffusion length of Mg in the heat treatment step is preferably set to not more than 1 mm. In order to diffuse Mg over a distance longer than 1 mm, heat treatment of an extremely long time is required. When arranging the entire B powder at the distance of not more than 1 mm from the boundary surface between Mg powder 3 and B powder 2 immediately before the heat treatment, therefore, particles of Mg powder 3 so diffuse into the entire B powder 2 in a short time that the heat treatment time can be reduced. When the heat treatment time is reduced, various effects can be attained in addition to the effect of reducing the time required for manufacturing the superconducting wire. For example, grain growth of superconducting crystals can be so suppressed that the number of grain boundaries in the superconducting crystals is increased to enlarge a pinning effect with the grain boundaries. Further, reaction between the superconducting crystals and a sheath material can be so suppressed in the heat treatment that the range of selection for the sheath material is widened.

While this embodiment has been described with reference to the multifilamentary wire, a superconducting wire of a single-filamentary structure having a single superconductor filament covered with a sheath may also be employed. Further, the superconducting wire to which the manufacturing method according to this embodiment is applied is not restricted to a round wire but may also be in the form of a tape. A tapelike superconducting wire is manufactured by rolling a wire at least either before heat treatment or after heat treatment, for example. Superconducting filaments can be densified by rolling the wire.

(Fourth Embodiment)

The manufacturing method according to the third embodiment has been described with reference to the case where the raw material powder is formed by only the Mg powder and the B powder. According to the present invention, however, the raw material powder may alternatively contain still another material in place of this case.

In a method of manufacturing a superconducting wire according to this embodiment, mixed powder (mixture) is prepared by mixing SiC and $B_4C$ with B powder. Then, Mg powder and this mixed powder are arranged in a mutually unmixed manner. For example, the mixed powder is arranged on the position where B powder 2 is arranged in Fig. 13. Thus, a superconducting wire having superconductor filaments of $MgB_2$ containing SiC and $B_4C$ is finally obtained.

The remaining manufacturing method is substantially similar to the third embodiment, and hence redundant description is not repeated.

In the method of manufacturing a superconducting wire according to this embodiment, the mixed powder is prepared by mixing SiC and $B_4C$ with B powder, for preparing a wire having a configuration obtained by covering raw material powder containing Mg powder 3 and the mixed powder not mixed with each other with a metal pipe 11 a.

Thus, a superconducting wire having superconductor filaments containing SiC and $B_4C$ is obtained, and the critical current density of the superconducting wire can be further improved.

While this embodiment has been described with reference to the case of preparing the mixed powder by mixing both of SiC and $B_4C$ with B, the present invention is not restricted to this case but mixed powder may be prepared by mixing at least either SiC or $B_4C$ with B.

(Fifth Embodiment)

Referring to Fig. 15, the cavities are formed in the heat-treated superconductor filament on the portions where Mg powder 3 has been arranged according to the third embodiment. These portions, not included in the superconductor filament (portion where B powder 2 is arranged), hardly influence the performance of superconducting wire 10. According to this embodiment, however, a low melting point metal is injected into such cavities, thereby stabilizing a superconductor. More specifically, a superconducting wire is manufactured through the manufacturing method according to the third embodiment, and a low melting point material having a melting point lower than a heat treatment temperature for Mg powder 3 and B powder 2 is injected into portions (cavities) where Mg powder 3 has been present in a liquid state. Solder or indium is employed as the low melting point metal, for example.

According to a method of manufacturing a superconducting wire of this embodiment, cavities present in superconductor filaments formed by reaction of the raw material powder can be filled up with the low melting point metal, whereby the superconductor can be stabilized as a result. In the structure obtained by embedding the superconductor filaments in the metal, gradients of a magnetic flux density and a temperature change caused in the superconductor are not much increased. Consequently, a flux jump so hardly takes place that transition to a normal conducting state can be suppressed.

While both of Mg and B are powdery in the first to fifth embodiments, Mg and B may not both be powdery in the present invention but may alternatively be green compacts obtained by compressing and solidifying powder or in massive states, for example. Further, materials prepared by shaping Mg and B into tapes or bars may also be employed. While each of the second and fourth embodiments has been described with reference to the case of employing the mixed powder prepared by mixing SiC and $B_4C$ with the B powder, the mixture prepared by mixing SiC and $B_4C$ with the B powder may not be powdery in the present invention but may alternatively be green compacts obtained by compressing and solidifying powder or in massive states, for example.

Examples of the present invention are now described.

(Example 1)

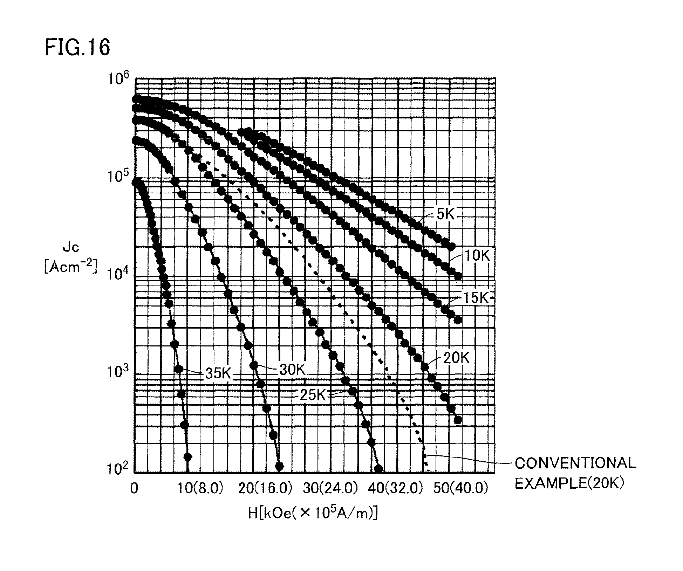

An effect of employment of a raw material body containing Mg and B not mixed with each other has been examined in this Example. More specifically, a superconducting wire was manufactured by the method according to the third embodiment. Heat treatment was performed at a temperature of 850°C for 24 hours. The sintering density of superconductor filaments in the superconducting wire obtained according to this method was at least 90 %. On the other hand, raw material powder prepared by mixing Mg powder and B powder with each other was employed for manufacturing a superconducting wire by a similar method as a conventional example. The sintering density of superconductor filaments in the conventional example was about 50 %. As to these obtained superconducting wires, the critical current densities $J_e$ were measured while varying the temperature in the range of 5 to 30 (K) and varying an applied magnetic field H in the range of 0 to 50 (kOe) (0 to $40.0 \times 10^5$ (A/m)). Fig. 16 shows the results. Referring to Figs. 16 to 18, the values of the applied magnetic fields H are shown in the units (Oe) and (A/m).

Referring to Fig. 16, the superconducting wire (temperature 20 (K)) according to this Example has a higher critical current density $J_e$ as compared with the conventional example (temperature 20 (K)). When the applied magnetic field H was 10 (kOe) ($8.0 \times 10^5$ (A/m)), for example, the critical current density $J_c$ of the superconducting wire according to this Example was $2.8 \times 10^5$ (A/cm$^2$), while the critical current density $J_c$ of the conventional example was $1.7 \times 10^5$ (A/cm$^2$). When the applied magnetic field H was 40 (kOe) ($32.0 \times 10^5$ (A/m)), the critical current density $J_c$ of the superconducting wire according to this Example was $2.6 \times 10^3$ (A/cm$^2$), while the critical current density $J_c$ of the conventional example was $7.0 \times 10^2$ (A/cm$^2$). The superconducting wire attained high critical current densities also at the remaining temperatures. Thus, it is understood that the critical current density can be improved by employing the raw material body containing Mg and B not mixed with each other.

(Example 2)

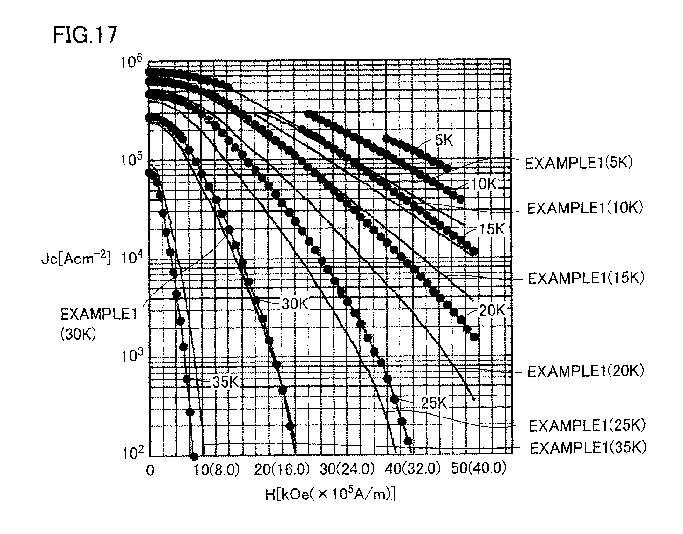

An effect of a raw material body further containing SiC has been examined in this Example. More specifically, mixed powder was prepared by mixing SiC and B powder with each other, and raw material powder was prepared without mixing Mg powder and this mixed powder with each other. SiC of about 30 nm in particle diameter was employed, with an atomic density of about 2 %. This raw material powder was employed for manufacturing a superconducting wire by a method similar to that in Example 1. As to the obtained superconducting wire, the critical current density $J_c$ was measured while varying the temperature in the range of 5 to 30 (K) and varying the applied magnetic field (H) in the range of 0 to 50 (kOe) (0 to $40.0 \times 10^5$ (A/m)). Fig. 17 shows the results. Fig. 17 also shows the results of the inventive superconducting wire according to Example 1 as Example 1.

Referring to Fig. 17, the superconducting wire according to this Example has a higher critical current density $J_c$ as compared with Example 1, particularly in the temperature range of not more than 25 (K). Referring to the data at the temperature of 20 (K), for example, the critical current density $J_c$ of the superconducting wire according to this Example was $4.1 \times 10^5$ (A/cm$^2$) while the critical current density $J_c$ of Example 1 was $2.8 \times 10^5$ (A/cm$^2$) when the applied magnetic field H was 10 (kOe) ($8.0 \times 10^5$ (A/m)). When the applied magnetic field H was 40 (kOe) ($32.0 \times 10^5$ (A/m)), the critical current density $J_c$ of the superconducting wire according to this Example was $7.3 \times 10^3$ (A/cm$^2$) while the critical current density $J_c$ of Example 1 was $2.6 \times 10^3$ (A/cm$^2$). Thus, it is understood that the critical current density can be further improved when the raw material body further contains SiC.

(Example 3)

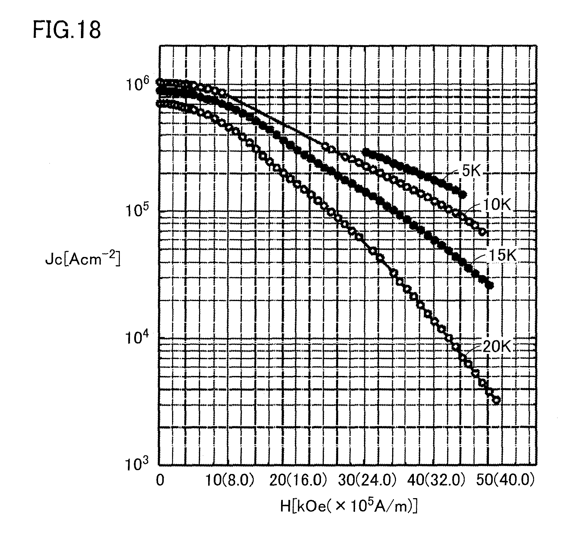

An effect of a raw material body further containing SiC and $B_4C$ has been examined in this Example. More specifically, mixed powder was prepared by mixing SiC and $B_4C$ with B powder, and raw material powder was prepared without mixing Mg powder and this mixed powder with each other. SiC of about 30 nm in particle diameter was employed, with an atomic density of about 2 %. The atomic density of $B_4C$ was set by simply replacing about 4 % of B contained in the raw material powder with $B_4C$. This raw material powder was employed for manufacturing a superconducting wire by a method similar to that in Example 1. As to the obtained superconducting wire, the critical current density $J_c$ was measured while varying the temperature in the range of 5 to 20 (K) and varying the applied magnetic field (H) in the range of 0 to 50 (kOe) (0 to $40.0 \times 10^5$ (A/m)). Fig. 18 shows the results.

Referring to Figs. 17 and 18, the superconducting wire according to this Example has a higher critical current density $J_c$ as compared with Example 1. Referring to the data at the temperature of 20 (K), for example, the critical current density $J_c$ of the superconducting wire according to this Example was $4.4 \times 10^5$ (A/cm$^2$) while the critical current density $J_c$ of Example 1 was $2.8 \times 10^5$ (A/cm$^2$) when the applied magnetic field H was 10 (kOe) ($8.0 \times 10^5$ (A/m)). When the applied magnetic field H was 40 (kOe) ($32.0 \times 10^5$ (A/m)), the critical current density $J_c$ of the superconducting wire according to this Example was $1.2 \times 10^4$ (A/cm$^2$) while the critical current density $J_c$ of Example 1 was $2.6 \times 10^3$ (A/cm$^2$). Thus, it is understood that the critical current density can be further improved when the raw material body further contains SiC and $B_4C$.

The present invention is applicable to superconducting apparatuses such as a superconducting transformer, a superconducting current limiter and a magnetic field generator employing superconducting magnets constituted of superconducting wires, a superconducting cable and a superconducting bus bar employing superconducting wires and a superconducting coil, and particularly applicable to a superconducting apparatus in which a superconducting wire is used in a state dipped in a coolant.

The embodiments and Examples disclosed in the above must be considered as illustrative in all points and not restrictive. The scope of the present invention is shown not by the aforementioned embodiments and Examples but by the scope of claim for patent, and intended to include all corrections and modifications within the meaning and range equivalent to the scope of claim for patent.

**Claims**

1. A sintered body (1a to 1c) containing magnesium and boron and having a sintering density of at least 90 %.

2. A superconducting apparatus employing the sintered body according to claim 1.

3. A method of manufacturing a sintered body (1a) containing magnesium and boron, comprising the arrangement and heat treatment steps of:

   arranging said magnesium (3a, 3b) and said boron (2) without mixing said magnesium and said boron with each other; and
   heat-treating said magnesium (3a, 3b) and said boron (2) with each other after said arrangement step.

4. The method of manufacturing a sintered body (1a) according to claim 3, wherein the temperature in said heat treatment step is at least 651 °C and not more than 1107°C.

5. The method of manufacturing a sintered body (1a) according to claim 3, wherein said arrangement step includes the steps of preparing a mixture (2) by mixing at least either silicon carbide or tetraboron carbide and said boron with each other and arranging said magnesium (3a, 3b) and said mixture without mixing said magnesium and said mixture with each other.

6. A superconducting wire (10) having a superconducting filament (1) containing magnesium and boron, wherein the sintering density of said superconducting filament is at least 90 %.

7. A superconducting apparatus employing the superconducting wire according to claim 6.

8. A method of manufacturing a superconducting wire (10) comprising the wire preparation and heat treatment steps of:

   preparing a wire (10a) having a configuration obtained by covering a raw material body containing magnesium (3) and boron (2) not mixed with each other with a metal (11a); and
heat-treating said wire.

9. The method of manufacturing a superconducting wire (10) according to claim 8, wherein the temperature in said heat treatment step is at least 651°C and not more than 1107°C.

10. The method of manufacturing a superconducting wire (10) according to claim 8, wherein said wire preparation step includes the steps of preparing a mixture (2) by mixing at least either silicon carbide or tetraboron carbide and said boron with each other and preparing said wire (10a) having a configuration obtained by covering said raw material body containing said magnesium (3) and said mixture not mixed with each other with said metal (11a).

11. The method of manufacturing a superconducting wire (10) according to claim 8, injecting a low melting point metal having a melting point lower than the temperature of said heat treatment into a portion where said magnesium has been present after said heat treatment step.

12. The method of manufacturing a superconducting wire (10) according to claim 8, so arranging said magnesium (3) as to extend in the longitudinal direction of said wire (10a) and so arranging said boron (2) as to enclose said magnesium in a section perpendicular to said longitudinal direction in said wire preparation step.

13. The method of manufacturing a superconducting wire (10) according to claim 8, so arranging said magnesium and said boron that entire said boron is present at a distance of at least 0 mm and not more than 1 mm from the boundary surface between said magnesium (3) and said boron (2) immediately before said heat treatment step.

FIG.1

1a

FIG.2

20

1b

FIG.3

20   20

1c

FIG.4

31

31a

3a 2 3b

Mg,B

FIG.5

31

31a

2
3
2

Mg,B

FIG.6

31

31a

2
3a
2
3b
2

Mg,B

FIG.7

## FIG.8

FIG.9

FIG.10

FIG.11

(a)

100 μm

(b)

1,000x  10.0 μm  WD 31.6mm  15kV  2004/08/30   10 μm

FIG.12

10

1  11

FIG.13

2

3

11a

10a

FIG.14

FIG.15

FIG.16

FIG.17

FIG.18

**EP 1 806 328 A1**

<div align="center">

## INTERNATIONAL SEARCH REPORT

</div>

| International application No. |
| --- |
| PCT/JP2005/019554 |

A. CLASSIFICATION OF SUBJECT MATTER
*C04B35/58*(2006.01), *H01B13/00*(2006.01), *C01G1/00*(2006.01), *H01B12/10*
(2006.01), *C01B35/04*(2006.01)

According to International Patent Classification (IPC) or to both national classification and IPC

B. FIELDS SEARCHED

Minimum documentation searched (classification system followed by classification symbols)
*C04B35/58*(2006.01), *C01B35/04*(2006.01)

Documentation searched other than minimum documentation to the extent that such documents are included in the fields searched
Jitsuyo Shinan Koho 1922-1996 Jitsuyo Shinan Toroku Koho 1996-2005
Kokai Jitsuyo Shinan Koho 1971-2005 Toroku Jitsuyo Shinan Koho 1994-2005

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | WO 2002/093659 A2 (EDISON S.P.A.),<br>21 November, 2002 (21.11.02),<br>Claim 1; page 12, line 20 to page 13, line 6;<br>page 16, line 12<br>(Family: none) | 1-4<br>5,11 |
| X<br><br>Y | JP 2002-324445 A (Sumitomo Electric Industries,<br>Ltd.),<br>08 November, 2002 (08.11.02),<br>Claims 7 to 9, 11; Par. No. [0028]<br>(Family: none) | 1-4,6-9,12,<br>13<br>5,10,11 |
| X<br>Y | JP 2002-222619 A (Hideyuki SHINAGAWA),<br>09 August, 2002 (09.08.02),<br>Par. No. [0005]<br>(Family: none) | 1-3,6-8,12<br>5,10 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>13 December, 2005 (13.12.05) | Date of mailing of the international search report<br>27 December, 2005 (27.12.05) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2005/019554 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | WO 2003/106373 A1 (UNIVERSITY OF WOLLONGONG), 24 December, 2003 (24.12.03), Claim 8 (Family: none) | 5,10 |
| Y | JP 2003-95642 A (National Institute of Advanced Industrial Science and Technology), 03 April, 2003 (03.04.03) Par. No. [0002] (Family: none) | 5,10 |
| A | JP 2004-269268 A (Independent Administrative Institution National Institute for Materials Science), 30 September, 2004 (30.09.04), Claims 1 to 6 & WO 2004/078650 A1 Claims 1 to 6 | 1-13 |
| A | JP 2002-352649 A (The Furukawa Electric Co., Ltd.), 06 December, 2002 (06.12.02), Claims 1 to 3 (Family: none) | 1-13 |
| A | JP 2004-143553 A (Japan Science and Technology Corp.), 20 May, 2004 (20.05.04), Claim 6 (Family: none) | 1-13 |
| A | JP 2003-2635 A (Pohang University of Science and Technology), 08 January, 2003 (08.01.03), Claims 1 to 4 (Family: none) | 1-13 |
| A | JP 2004-532171 A (Iowa State University Research Foundation), 21 October, 2004 (21.10.04), Claim 1 & WO 2002/064859 A2 Claim 1 & US 2002/0111275 A1 & EP 1368135 A1 | 1-13 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **ALEXEY, V. PAN et al.** Properties of superconducting MgB2 wires: in situ versus ex situ reaction technique. *Supercond. Sci. Technol.,* 2003, vol. 16, 639-644
- **X. L. WANG.** Significant improvement of critical current density in coated MgB2/Cu short tapes through nano-SiC doping and short-time in situ reaction. *Supercond. Sci. Technol.,* 2004, vol. 17, L21-L24
- **A. MATSUMOTO et al.** Effect of impurity additions on the microstructures and superconducting properties of in situ-processed MgB2 tapes. *Supercond. Sci. Technol.,* 2004, vol. 17, S319-S323